# FASCICULE DE BREVET EUROPEEN

(11) **EP 0 468 901 B1**
(45) Date de publication et mention de la délivrance du brevet: **03.01.1996**
(21) Numéro de dépôt: 91420266.8
(22) Date de dépôt: 22.07.1991
(51) Int. Cl.: H01L 21/82, H01L 27/115

(54) **Procédé de fabrication de mémoire EPROM à drain et source de structures différentes**
Verfahren zur Herstellung eines EPROM-Speichers mit unterschiedlichen Source- und Drain-Strukturen
Method of fabricating an EPROM memory with a different structure for source and drain

(30) Priorité: 24.07.1990 FR 9009718
(43) Date de publication de la demande: 29.01.1992
(73) Titulaire: SGS-THOMSON MICROELECTRONICS S.A., F-94250 Gentilly (FR)
(72) Inventeur: Guillaumot, Bernard, F-38120 Le Fontanil (FR); Laurens, Michel, F-38120 Saint Egreve (FR)
(74) Mandataire: de Beaumont, Michel

(56) Documents cités:
- EP-A- 0 368 097
- US-A- 4 829 351

## Description

La présente invention concerne les mémoires à semi-conducteur et plus particulièrement les mémoires à grille flottante, non volatiles et électriquement programmables, couramment appelées mémoires EPROM, telles que décrites par exemple dans le brevet US-A-4 829 351.

Pour obtenir des mémoires grande capacité de stockage,par exemple des mémoires capables de stocker jusqu'à 16 Mégabits, on doit réduire le plus possible la dimension de chacune des cellules constituant la mémoire, Mais on est évidemment limité par des considérations physiques et notamment par la finesse des motifs que permettent les étapes de photolithographie. On est limité aussi par les paramètres électriques parasites qui sont dus au processus de fabrication et qui perturbent le fonctionnement de la mémoire.

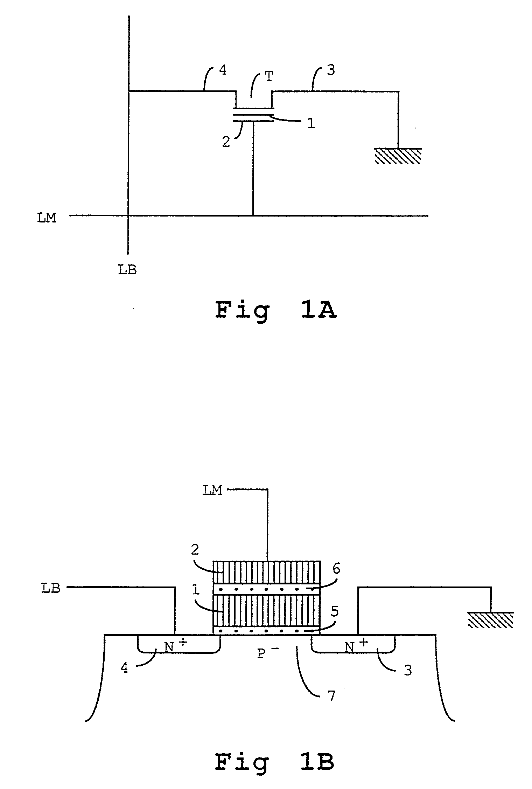

La figure 1A représente un transistor T d'un point mémoire à grille flottante. Ce transistor possède une grille flottante 1 et une grille de commande 2, ainsi que deux régions semiconductrices d'un premier type de conductivité (source 3 et drain 4) séparées par une région de canal d'un type de conductivité opposé recouverte par la grille flottante 1 et la grille de commande 2.

La grille de commande 2 est reliée à une ligne de mot IM. Le drain 4 est relié à une ligne de bit LB. La source 3 est reliée à la masse.

Pour programmer, ou écrire, un tel point mémoire, on charge la grille flottante 1 par injection de porteurs chauds, en appliquant à la grille de commande 2, pendant que le transistor conduit un courant entre ses régions de source 3 et de drain 4, un potentiel suffisamment élevé pour que les porteurs de charge (électrons) soient attirés et piégés dans la grille flottante. Cette opération d'écriture a pour effet d'augmenter le seuil de conduction du transistor qui, une fois programmé, ne conduira le courant que pour des valeurs de potentiel appliqué sur sa grille de commande plus élevées qu'en l'absence de programmation.

Lors de la lecture de l'information contenue dans un point mémoire, on applique à la grille de commande du transistor de ce point mémoire une tension à la fois supérieure à la tension de seuil de déclenchement de conduction à l'état non-programmé et inférieure à la tension de seuil de déclenchement de conduction à l'état programmé. Si le transistor conduit quand une différence de potentiel adaptée est appliquée entre la source et le drain, le point mémoire est à l'état non-programmé. Si le transistor ne conduit pas, le point mémoire est à l'état programmé.

Le potentiel appliqué à la grille de commande lorsqu'on programme le point mémoire, ou potentiel de programmation VPP, est par exemple de 15 volts. Le potentiel de drain VCC est alors par exemple de 10 volts et le potentiel de source VSS est par exemple 0 volt ou la masse.

Le potentiel appliqué à la grille de commande lors de la lecture du point mémoire est par exemple de 5 volts. Le potentiel de drain VCC est alors par exemple de 1,5 volts, et le potentiel de source VSS est par exemple 0 volt ou la masse.

La figure 1B représente une vue en coupe d'un point mémoire implanté dans une tranche de silicium. Le transistor comprend une grille flottante 1, une grille de commande 2, une région de source 3 et une région de drain 4. La source et le drain sont deux régions semiconductrices d'un premier type de conductivité, par exemple N⁺, séparées par une région de canal 7 d'un type de conductivité opposé, par exemple P-.

La grille flottante 1 du transistor est réalisée par un premier niveau de silicium polycristallin (poly 1). Elle est séparée du substrat par une couche mince de dioxyde de silicium 5, appelée couche d'oxyde de grille. Une couche de dioxyde de silicium 6 est présente entre les couches de grilles 1 et 2. La grille de commande 2 est réalisée par un deuxième niveau de silicium polycristallin (poly 2). La couche de dioxyde de silicium 6 est appelée couche d'oxyde interpoly.

L'un des problèmes pour la réalisation de mémoires EPROM comprenant un grand nombre de cellules du type de celle illustrée très schématiquement en figure 1B est d'assurer avec le minimum de perte de surface la connexion entre tous les drains des cellules d'une même colonne (ligne de drain ou de bit) et entre toutes les grilles de commande d'une même rangée (ligne de mot), tout en reliant toutes les sources à la masse.

Ceci doit être effectué non seulement en rendant minimale la surface occupée, mais aussi en faisant que les connexions entre cellules soient suffisamment conductrices pour éviter des chutes de tension sur les lignes de mot, de bit ou de masse.

En outre, c'est un objet de la présente invention de réaliser une telle structure dans laquelle les lignes de bits (drains) et les lignes de masse (sources) soient nettement différenciées.

Pour atteindre ces objets, la présente invention prévoit un procédé de fabrication d'une architecture de mémoire comprenant les étapes consistant à :
- former des colonnes d'oxyde épais délimitant des régions dans lesquelles seront formées les colonnes de cellules de mémoire ;
- former un empilement de grille comprenant une couche d'isolement de grille, un premier niveau de silicium polycristallin de grille flottante, une couche d'isolement entre grilles, un deuxième niveau de silicium polycristallin de grille de commande associé à une couche de siliciure, et une couche isolante supérieure,
- former au-dessus de cet empilement une couche mince d'un troisième niveau de silicium polycristallin ;
- graver cet ensemble de couches pour définir des structures de grille, cette gravure s'effectuant jusqu'au silicium du substrat entre les colonnes d'oxyde épais ;
- masquer les régions où les zones de drain sont apparentes ;
- effectuer la gravure de la région d'oxyde de champ entre des sources d'une même rangée ;
- implanter (N⁺) les régions de drains, de sources, et entre sources ;
- disposer un isolant pour remplir les espaces entre empilements de grille au-dessus des sources et pour former des espaceurs latéraux sur les côtés des empilements tournés vers les drains;
- graver de façon anisotrope la couche d'isolant de remplissage pour dégager les surfaces apparentes de silicium au niveau des drains et de ladite couche de troisième niveau de silicium polycristallin ;
- réoxyder ladite couche de silicium polycristallin ;
- graver la partie réoxydée jusqu'à obtenir le dénudement des régions de drain ;
- déposer une couche conductrice de contact de drain en un métal réfractaire ; et
- graver la partie réoxydée jusqu'à obtenir le dénudement des régions de drain ;
- déposer une couche conductrice de contact de drain ; et
- réaliser les opérations finales classiques de métallisation.

Selon un mode de réalisation de l'invention, la couche conductrice est en un métal réfractaire et les étapes de métallisation comportent une reprise de contact par de l'aluminium.

On notera également que les étapes liées à la formation du troisième niveau de silicium polycristallin sont optionnelles.

Ces objets, caractéristiques et avantages ainsi que d'autres de la présente invention seront exposés plus en détail dans la description suivante de modes de réalisation particuliers faite en relation avec les figures jointes parmi lesquelles :
les figures 1A et 1B décrites précédemment rappellent l'allure d'un point mémoire EPROM ;
la figure 2 représente de façon extrêmement schématique et symbolique une vue de dessus d'un ensemble de cellules obtenues selon la présente invention ;
la figure 3 représente une vue de dessus partielle de cellules obtenues selon la présente invention à un stade intermédiaire de fabrication ;
la figure 4 illustre une coupe A-A de la figure 3 après définition des grilles ;
les figures 5A et 5B illustrent des coupes B-B de la figure 3 lors d'étapes successives de définition des sources ;
les figures 6 à 8 représentent des coupes A-A de la figure 3 lors d'étapes successives de fabrication ;
la figure 9 représente une coupe C-C de la figure 3 après gravure du métal ;
la figure 10 représente une coupe D-D de la figure 3 après gravure de métal ; et
la figure 11 représente en vue de dessus partielle d'un mode de réalisation particulier de la présente invention.

On notera que, comme cela est usuel dans la représentation des circuits intégrés, les dimensions latérales et d'épaisseur des diverses couches ne sont pas tracées à l'échelle ni à l'intérieur d'une figure donnée, ni d'une figure à l'autre, les diverses dimensions étant arbitrairement dilatées ou contractées pour simplifier la lisibilité et le tracé des figures.

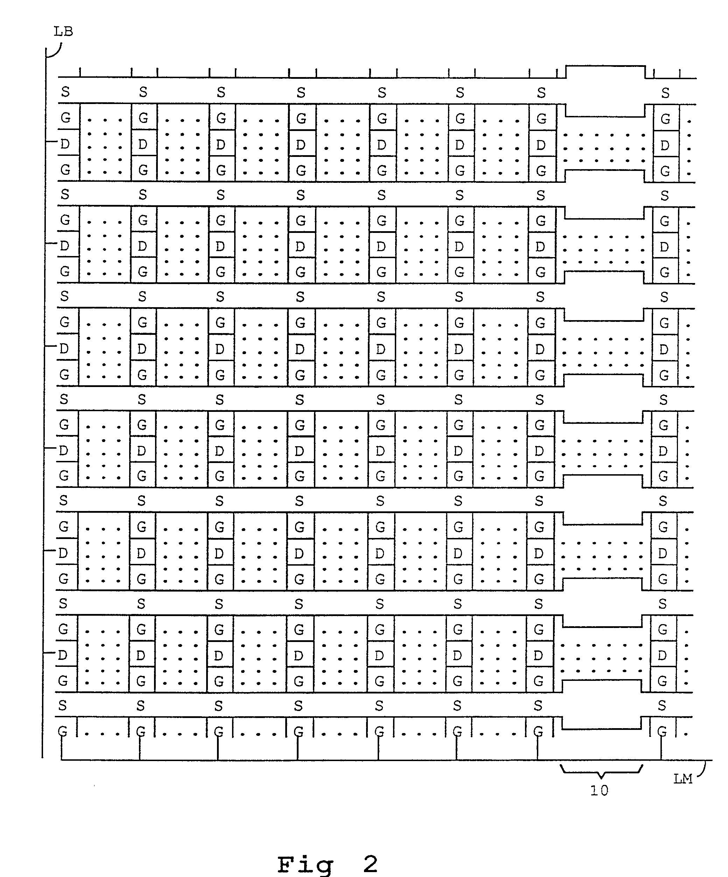

La figure 2 est une vue de dessus symbolique et extrêmement schématique d'un ensemble de cellules de mémoire. Elle est uniquement destinée à faciliter la compréhension de la topologie de la mémoire. On a désigné par S, G, D les régions de source, de grille et de drain d'un transistor élémentaire. Chacun de ces transistors est orienté dans la direction des colonnes dans la représentation de la figure 2. Ainsi, verticalement, on trouve successivement une région de source S (diffusion N⁺), une région de grille G (grille flottante et grille de commande) puis une région de drain D (diffusion N⁺) et à nouveau une région de grille et une région de source, et ainsi de suite. Les zones pointillés désignent des zones d'oxyde épais ou oxyde de champ séparant des colonnes de transistors adjacents sauf aux emplacements des sources.

Les diffusions N⁺ de source sont continues selon des rangées alors que les diffusions de drain sont en forme d'îlots isolés.

On note dans la figure 2, un ensemble de colonnes répétitives et une colonne 10 où la région d'oxyde est plus large. La colonne 10 est destinée à reprendre des contacts de source comme on le verra ci-après.

Toutes les grilles de commande d'une même rangée (horizontale dans la figure) sont interconnectées comme le verra ci-après par une ligne de mot LM correspondant à un deuxième niveau de silicium polycristallin et à du siliciure.

Tous les drains des transistors d'une même colonne (verticale) sont interconnectés, comme on le verra ci-après, par une ligne de bit LB en un métal réfractaire formée au-dessus du deuxième niveau de silicium polycristallin.

Il apparaîtra à la lecture de la description ci-après que l'architecture de mémoire illustrée schématiquement en figure 2 se prête à une réalisation hautement miniaturisée du fait que de nombreuses étapes successives peuvent être autoalignées et donc que l'on arrive aux dimensions minimales pour une technologie donnée.

En pratique, on pourra réaliser une mémoire selon la présente invention en répétant horizontalement des groupes de 16 cellules élémentaires séparées par une colonne de reprise de source telle que la colonne 10 de la figure 2 et, verticalement, on pourra trouver plus de 1000 transistors par colonne. On notera d'ailleurs, ci-après que la présente invention permet de minimiser le nombre de reprises de contact de drain sur le réfractaire susmentionné, éventuellement à un seul contact tous les 1000 transistors.

Dans la description ci-après de la présente invention, on s'attachera tout particulièrement à la structure de la zone mémoire elle-même. Il sera clair pour l'homme de l'art que, sur la même puce de circuit intégré que celle incorporant la mémoire, seront également prévus des transistors classiques, par exemple des transistors de décodage de mémoire ou autres transistors faisant partie d'un composant. Comme cela est connu de l'homme de l'art dans le domaine de la fabrication des circuits intégrés, ces autres transistors, qui comprendront habituellement une seule grille de commande et pas de grille flottante, pourront être réalisés lors des mêmes étapes de fabrication que celles des transistors à grille flottante selon l'invention. L'invention se prête d'ailleurs tout particulièrement à une telle combinaison.

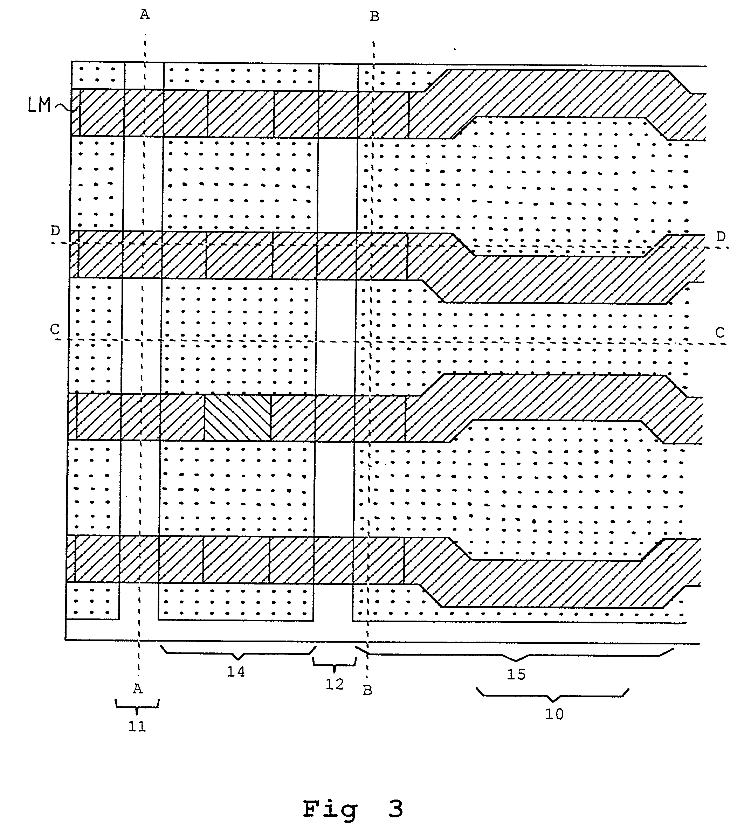

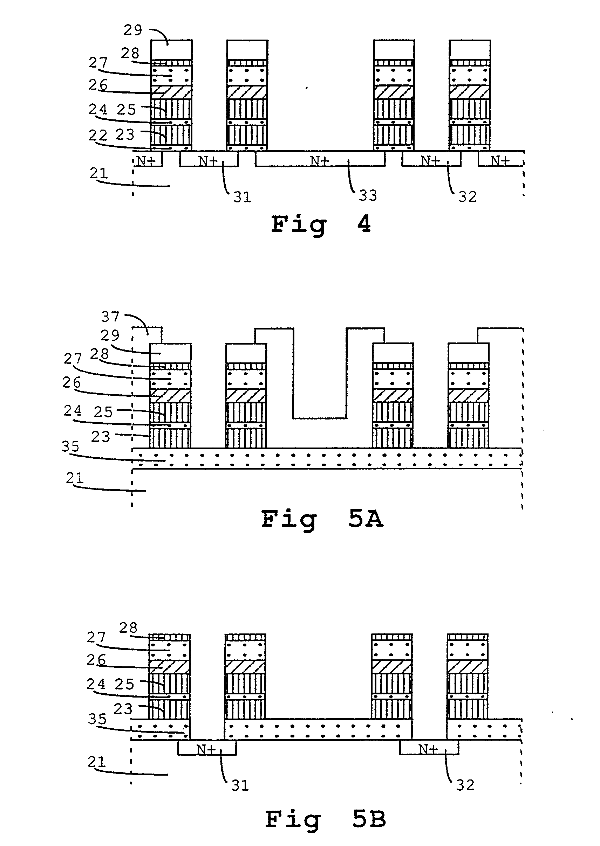

La figure 3 représente en vue de dessus une portion de mémoire selon la présente invention à une étape intermédiaire de fabrication (correspondant à celle des figures 4 et 5A qui seront décrites ci-après). On peut voir deux colonnes 11 et 12 où seront formés des transistors à côté d'une colonne 10 où seront formées des zones de reprise de contact de source. Cette figure 3 est un peu plus réaliste que la figure 2 et est essentiellement destinée à servir de repère pour les vues en coupe qui seront décrites ci-après. L'accolade 14 désigne les limites d'une colonne d'oxyde épais formée entre deux colonnes de transistors et l'accolade 15, les limites d'une colonne d'oxyde épais encadrant la zone 10 qui servira aux reprises de contact de source.

Cette structure sera décrite ci-après en relation avec diverses vues en coupe à divers stades de fabrication.

La figure 4 représente une vue en coupe selon la ligne A-A de la figure 3 à un stade intermédiaire de fabrication alors que seules les zones d'oxyde épais ont été formées et que l'on a déposé et gravé de façon classique toutes les couches successives destinées à former les grilles flottantes et de commande.

Plus particulièrement, on voit en figure 4, sur un substrat de silicium monocristallin 21 une première couche d'oxyde de grille 22, un premier niveau de silicium polycristallin (poly 1) 23 correspondant aux grilles flottantes, une couche d'oxyde mince 24 (couche d'oxyde interpoly), un deuxième niveau de silicium polycristallin (poly 2) 25 correspondant aux grilles de commande, une couche d'un siliciure de métal réfractaire 26, une couche d'oxyde de silicium épais 27, un troisième niveau de silicium polycristallin 28 et une couche de résine 29.

Dans la représentation de la figure 4, le masque de résine 29 a été gravé selon un motif choisi pour délimiter des régions de source 31 et 32 et une région de drain centrale 33. (On retrouve également des régions de drain à l'extérieur des régions de source 31 et 32). La région de drain 33 est plus large que les régions de source 31 et 32, pour des raisons qui apparaîtront ci-après.

On notera que l'une des originalités de la présente invention réside dans la prévision du troisième niveau de silicium polycristallin 28.

Les figures 5A et 5B représentent des vues en coupe dans la même direction que la figure 4, mais selon la ligne B-B de la figure 3. Cette coupe, au lieu de se situer au milieu d'une colonne de transistor, se situe légèrement à l'écart de cette colonne dans une région où se trouve de l'oxyde de champ, 35.

La figure 5A représente l'état de la structure alors que l'on a gravé les couches de grille 22 à 29 mais avant de réaliser les implantations de drain et de source. La gravure des couches de grille se prolonge jusqu'à la couche d'oxyde épais 35.

Après cette gravure, une couche de résine 37 masque les régions de drain. Ensuite, comme le représente la figure 5B, la couche d'oxyde épais 35 est gravée au niveau des sources, et les diffusions de source 31 et 32 sont effectuées en même temps que la diffusion de drain 33 illustrée en figure 4. La structure de la figure 5B est également représentée après enlèvement des couches de résine supérieures 29 et 37.

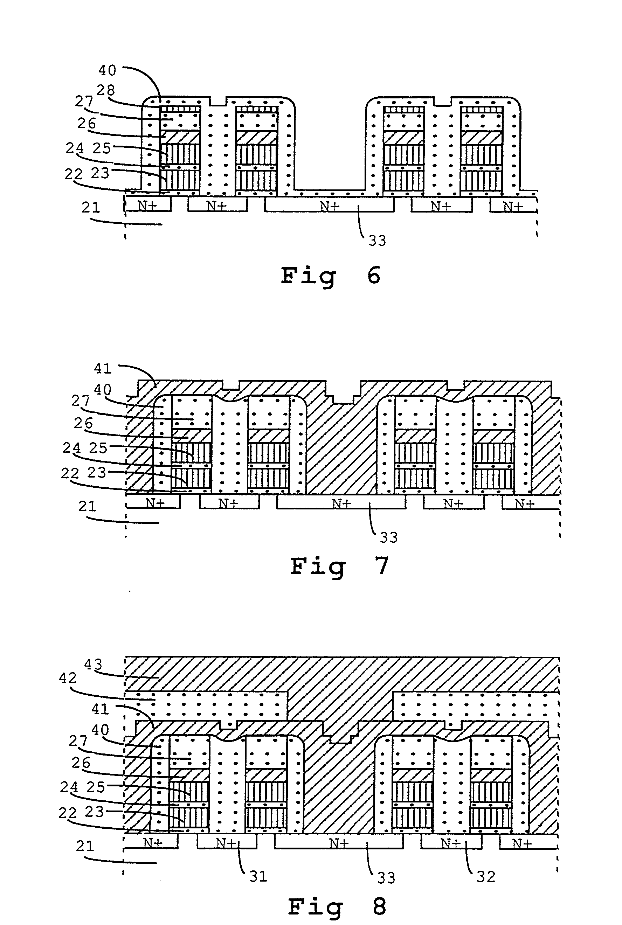

Les figures 6 à 8 représentent des coupes A-A à des phases successives de fabrication ultérieures à celles illustrées en figures 4 et 5.

Comme le représente la figure 6, une couche d'oxyde 40 est déposée par voie chimique en phase vapeur de façon à remplir les intervalles relativement étroits entre les motifs de grille situés de part et d'autre d'une région de source et à former des espaceurs sur les parois verticales des motifs de grille de part et d'autre d'un motif de drain. En effet, comme on l'a vu précédemment, les régions de drain sont nettement plus larges que les régions de source (à l'exception des régions de reprise de contact de source).

A l'étape illustrée en figure 7, on a procédé à une attaque anisotrope verticale de la couche d'oxyde 40 pour l'enlever au-dessus des surfaces de silicium et plus particulièrement au-dessus de la région de drain dopée N⁺ 33. Lors de cette étape d'enlèvement, la couche de silicium 28 (troisième niveau de silicium polycristallin) sert à arrêter la gravure au-dessus de l'empilement de couches de grille. Après quoi, on oxyde cette couche 28 (en même temps d'ailleurs que s'oxyde la partie apparente de la région de drain 33, cette partie apparente s'oxydant néanmoins moins vite du fait qu'il s'agit de silicium mono et non polycristallin). La couche de troisième niveau de silicium polycristallin ayant une épaisseur faible et bien déterminée, son oxydation puis l'enlèvement de la couche d'oxyde formée simultanément sur la région de drain 33 se fait en consommant une épaisseur d'oxyde relativement bien déterminée. Il en résulte que l'épaisseur de la région d'oxyde 27 restante peut être déterminée avec précision. Ceci constitue un avantage important par rapport aux structures de l'art antérieur, dans lesquelles cette épaisseur est mal déterminée à la suite des diverses étapes d'oxydation et de gravure d'oxyde. Cette épaisseur, bien que non critique, doit être aussi faible que possible pour permettre une accélération du procédé de fabrication tout en étant suffisamment élevée pour maintenir à une valeur raisonnable, et de préférence connue, les capacités parasites entre les grilles de commande et les métallisations déposées ensuite.

A la figure 7, après l'élimination de la couche d'oxyde sur la région de drain et dans les régions de reprise de contact de source 10, on a illustré le dépôt d'une couche d'un métal conducteur, de préférence un métal réfractaire tel que du tungstène 41 qui sera gravé selon des colonnes. Cette liaison étant à haute conductivité, elle permet de réaliser seulement un petit nombre de reprises de contact entre les colonnes de drain et les colonnes de reprise de contact de source avec une métallisation supérieure classique, couramment en aluminium.

On pourra ensuite de façon relativement classique et comme le représente la figure 8, déposer une couche d'oxyde de planarisation 42, puis une couche d'un métal de reprise de contact 43, par exemple de l'aluminium. En figure 8, on a représenté une ouverture dans la couche d'oxyde de planarisation 42 et un contact entre la couche d'aluminium 43 et la couche de tungstène 41.

L'essentiel de la présente invention a été décrit dans ce qui précède. Les figures suivantes sont notamment destinées à mieux faire comprendre l'architecture de la mémoire selon la présente invention.

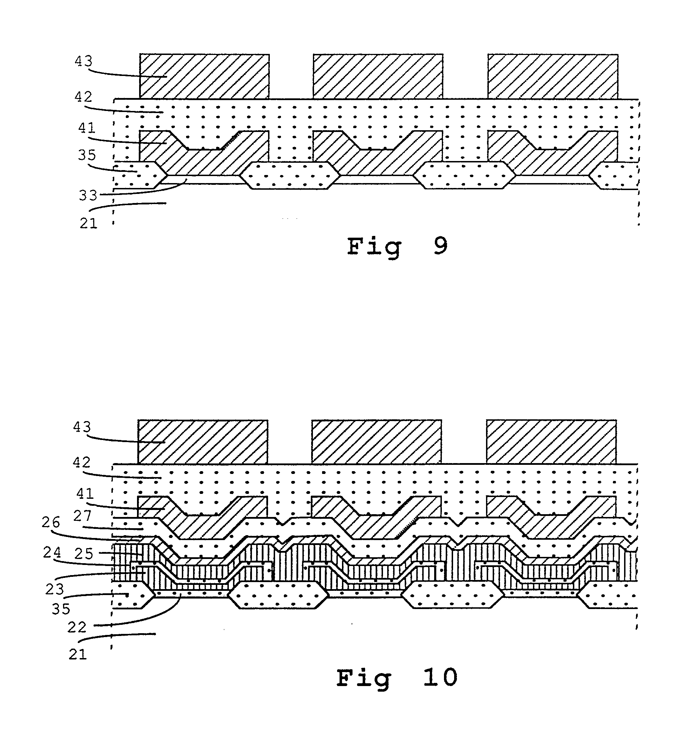

La figure 9 représente une vue en coupe selon la ligne C-C de la figure 3, c'est-à-dire perpendiculairement à des régions de drain. On retrouve dans cette figure les régions de diffusion de drain 33, d'oxyde de champ 35, de métallisation de drain 41, d'isolement 42 et de métallisation 43. Dans le cas de la figure 9, on a représenté une situation où la coupe est effectuée en dehors de régions de contact entre les métallisations 43 et les métallisations de drain 41.

La figure 10 représente une vue en coupe selon la ligne D-D de la figure 3, c'est-à-dire au niveau des grilles des cellules de mémoire. Cette figure se comprend d'elle-même à partir de la description précédente. On y a seulement reporté les références correspondant à celles des figures précédentes. On notera que la liaison de grille de commande à grille de commande selon une rangée se fait par l'ensemble du deuxième niveau de silicium polycristallin 25 et du siliciure de métal réfractaire 26. Il s'agit donc d'une liaison à haute conductivité qui constitue directement une ligne de mot.

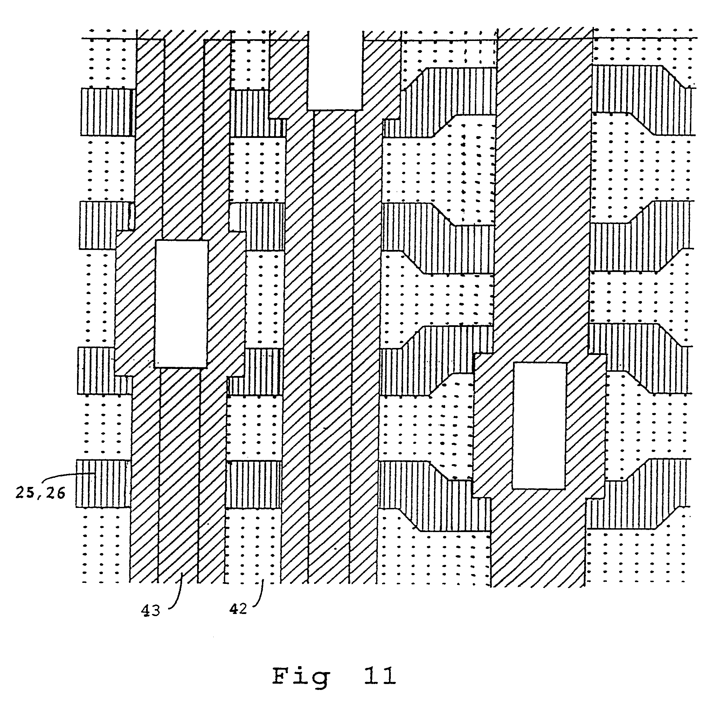

Enfin, la figure 11 représente une vue de dessus analogue à celle de la figure 3 mais dans le cadre d'un mode de réalisation particulier où l'on a représenté en plus, par des rectangles, des reprises de contact de drain et des reprises de contact de source, c'est-à-dire, en ce qui concerne les drains, un contact entre la couche de tungstène 41 et la couche d'aluminium supérieure et, en ce qui concerne les sources, un contact entre la couche d'aluminium supérieure et la couche de tungstène de source qui est élargie, comme on l'a indiqué en relation avec la figure 2, une fois toutes les seize cellules. Etant donné qu'il n'est pas nécessaire de reprendre un contact avec chaque région de reprise de source et chaque région de drain, il est possible, comme cela est représenté, d'élargir les zones de contact, ce qui simplifie le processus de fabrication.

La présente description est relativement succinte en ce qui concerne la mise en oeuvre des étapes de fabrication car celles-ci sont bien connues de l'homme de l'art. On pourra utiliser des techniques connues de dépôt et de croissance thermique de couches et des techniques de masquage et de gravure anisotrope, par exemple des gravures sèches assistées par plasma (RIE). En effet, on connaît maintenant de tels procédés de gravure qui sont bien anisotropes et nettement sélectifs entre les divers matériaux mentionnés précédemment, et notamment entre le silicium et l'oxyde de silicium.

Par ailleurs, diverses couches d'isolement ont été mentionnées simplement comme étant des couches d'oxyde de silicium (SiO₂). L'homme de l'art saura choisir d'autres isolants ou combinaison d'isolants pour certaines de ces couches par exemple des sandwich oxyde-nitrure-oxyde de silicium (ONO). D'autres couches isolantes pourront être dopées de façon à favoriser leurs propriétés de fluage. De plus, diverses variantes pourront être apportés au procédé de l'invention. Par exemple, on pourra supprimer l'étape de dépôt de la couche de silicium polycristallin 28 à condition de réaliser ensuite des opérations contrôlées d'attaque partielle d'oxyde de silicium.

A titre purement indicatif d'exemple de valeurs numériques, on pourra, dans la pratique, adopter pour les épaisseurs des diverses couches les valeurs suivantes :

| | |
|---|---|
| Couche d'oxyde de grille 22 : | 10 nm |
| Premier niveau de silicium polycristallin : | 100 nm |
| Couche d'oxyde interpoly 24 : | 10 nm |
| Deuxième niveau de silicium polycristallin 25 : | 550 nm |
| Couche de siliciure réfractaire 26 : | 150 nm |
| Couche d'oxyde supérieure 27 : | 300 nm |
| Troisième niveau de silicium polycristallin 28 : | 50 nm |
| Couche d'oxyde de champ 35 : | 500 nm |

De même, on pourra obtenir un pas dans la direction des lignes de 1,5 micromètres et dans la direction des colonnes de 1,15 micromètres, ce qui correspond à une surface de point mémoire de 1,725 micromètres carrés.

## Revendications

1. Procédé de fabrication d'une mémoire EPROM,comprenant les étapes consistant à :
- former des colonnes d'oxyde de champ épais (14) sur un substrat de silicium délimitant des régions dans lesquelles seront formées les colonnes de cellules de mémoire ;
- former un ensemble de couches empilées comprenant une couche d'isolement de grille (22), un premier niveau de silicium polycristallin de grille flottante (23), une couche d'isolement entre grilles (24), un deuxième niveau de silicium polycristallin de grille de commande (25) réoouverte par une couche de siliciure (26),et une couche isolante supérieure (27),
caractérisé en ce qu'il comprend en outre les étapes suivantes :
- graver ledit ensemble de couches pour définir des structures de grille, formant des lignes transversales par rapport aux colonnes d'oxyde de champ et délimitant respectivement de part et d'autre de chaque ligne des bandes dans lesquelles des régions de source et de drain desdites cellules de mémoire sont à former, cette gravure s'effectuant jusqu'au silicium de substrat entre les colonnes d'oxyde ;
- former un masque (37) sur lesdites bandes dans lesquelles les régions de drain sont à former ;
- effectuer la gravure des régions d'oxyde de champ exposées, en utilisant ledit masque et les structures de grille comme masque;
- implanter les régions de drain et de source et les régions entre sources ;
- disposer une couche d'isolant (40) pour remplir les espaces entre les structures de grille au-dessus des régions de source et pour former des espaceurs latéraux sur les côtés des structures de grille au-dessus des régions de drain ;
- graver de façon anisotrope ladite couche d'isolant (40) pour dégager les surfaces de silicium des régions de drain ;
- déposer une couche conductrice (41) en contact avec les régions de drain ; et
- former des métallisations.

2. Procédé selon la revendication 1, caractérisé en ce que ladite couche conductrice (41) est en un métal réfractaire.

3. Procédé selon la revendication 1, caractérisé en ce que l'étape consistant à former des métallisations comprend la formation de contacts de source et la reprise des contacts de drain par une métallisation supérieure.

4. Procédé selon la revendication 1, caractérisé en ce qu'il comprend les étapes supplémentaires suivantes :
- former au-dessus de l'ensemble de couches empilées une couche mince d'un troisième niveau de silicium polycristallin (28) ;
- oxyder ladite couche du troisième niveau de silicium polycristallin et les régions de drain, après la gravure de la couche d'isolant (40) ; et
- graver l'oxyde formé sur les régions de drain de façon à dénuder les régions de drain, avant le dépôt de ladite couche conductrice (41).

## Patentansprüche

1. Verfahren zum Herstellen eines EPROM-Speichers, mit folgenden Verfahrensschritten:
- Bilden von dicken Feldoxidsäulen (14) auf einem Siliziumsubstrat, welches Bereiche eingrenzt, in denen Speicherzellensäulen gebildet werden,
- Bilden einer Anordnung von gestapelten Schichten, welche eine Gittertrennschicht (22), eine erste Polysiliziumebene mit offenem Gitter (23), eine Isolierschicht zwischen Gittern (24), eine zweite Polysiliziumebene mit Steuergitter (25), welche von einer Silizidschicht (26) bedeckt wird, und eine obere Isolierschicht (27) aufweist, **gekennzeichnet** durch die weiteren Verfahrensschritte:
- Ätzen der Anordnung von Schichten zum Definieren von Gitterstrukturen, Bilden von Linien, welche quer zu den Feldoxidsäulen verlaufen und jeweils zu beiden Seiten jeder Linie Bänder eingrenzen, in denen Sourcebereiche und Drainbereiche dieser Speicherzellen gebildet werden, wobei das Ätzen bis zu dem Siliziumsubstrat zwischen den Oxidsäulen ausgeführt wird,
- Bilden einer Maske (37) auf den Bändern, in denen die Drainbereiche ausgebildet werden,
- Ätzen der freiliegenden Feldoxidbereiche unter Verwendung dieser Maske und der Gitterstrukturen als Maske,
- Implantieren der Drainbereiche und der Sourcebereiche und der Bereiche zwischen den Sources,
- Aufbringen einer Isolierschicht (40), um die Räume zwischen den Gitterstrukturen über den Sourcebereichen zu füllen und um seitliche Abstandshalter an den Seiten der Gitterstrukturen über den Drainbereichen zu bilden,
- anisotropes Ätzen dieser Isolierschicht (40), um die Siliziumoberflächen der Drainbereiche freizulegen,
- Aufbringen einer leitenden Schicht (41) in Kontakt mit den Drainbereichen, und
- Bilden von Metallisierungen.

2. Verfahren nach Anspruch 1, **dadurch gekennzeichnet**, daß die leitende Schicht (41) aus einem hitzebeständigen Metall besteht.

3. Verfahren nach Anspruch 1, **dadurch gekennzeichnet**, daß der Schritt, bei dem die Metallisierungen gebildet werden, das Bilden von Sourcekontakten und das Ausbessern von Drainkontakten mit einer oberen Metallisierung umfaßt.

4. Verfahren nach Anspruch 1, **gekennzeichnet** durch die weiteren folgenden Verfahrensschritte:
- Bilden einer dünnen Schicht aus einer dritten Polysiliziumebene (28) über der Anordnung aus gestapelten Schichten,
- Oxidieren dieser Schicht der dritten Polysiliziumebene und der Drainbereiche nach dem Ätzen der Isolierschicht (40), und
- Wegätzen des Oxids, welches sich auf den Drainbereichen gebildet hat, um die Drainbereiche vor dem Aufbringen der leitenden Schicht (41) freizulegen.

## Claims

1. A method for manufacturing an EPROM memory, comprising the steps of:
- forming thick field oxide columns (14) on a silicon substrate defining regions in which columns of memory cells will be formed;
- forming a set of stacked layers comprising a gate insulating layer (22), a floating gate first polysilicon level (23), an insulating layer between gates (24), a control gate second polysilicon level (25) covered by a silicide layer (26), and an upper insulating layer (27);
characterized in that it further comprises the following steps:
- etching said set of layers to define gate structures, forming lines transversely to the field oxide colums and defining respectively on each side of each line strips in which source and drain regions of said memory cells are to be formed this etching being carried out up to the silicon substrate between the oxide columns;
- forming a mask (37) on said strips where the drain areas are to be formed;
- etching the exposed field oxide region using said mask and the gate structures as a mask;
- implanting the drain regions, the source regions, and the regions between sources;
- depositing an insulating layer (40) filling the spaces between the gate structures above the source regions and forming lateral spacers on the sides of the gate structures above the drain regions;
- anisotropically etching said insulating layer (40) to clear the silicon surfaces of the drain regions;
- depositing a drain contact conductive layer (41); and
- forming metallizations.

2. A method as claimed in claim 1, characterized in that said conductive layer (41) is made of a refractory metal.

3. A method as claimed in claim 1, characterized in that the metallization step comprises the formation of source contacts and the relaying of the source and drain contacts by an upper metallization.

4. A method as claimed in claim 1, characterized in that it further comprises the steps of:
- forming above the set of stacked layers a thin layer of a third polycrystalline silicon level (28);
- oxidizing said layer of the third polysilicon level and the drain regions, after the etching of the insulating layer (40); and
- etching away the oxyde formed on the drain regions so as to bare the drain regions before depositing said conductive layer (41).
